# EUROPÄISCHE PATENTSCHRIFT

(11) **EP 2 260 313 B1**
(45) Veröffentlichungstag und Bekanntmachung des Hinweises auf die Patenterteilung: **30.05.2012**
(21) Anmeldenummer: 09728712.2
(22) Anmeldetag: 26.03.2009
(51) Int. Cl.: G01R 31/36

(54) **VERFAHREN UND EINE VORRICHTUNG ZUR ÜBERWACHUNG DES BETRIEBSZUSTANDES EINER BATTERIE**
METHOD AND DEVICE FOR MONITORING THE OPERATING STATE OF A BATTERY
PROCÉDÉ ET DISPOSITIF DE CONTRÔLE DE L'ÉTAT DE FONCTIONNEMENT D'UNE BATTERIE

(30) Priorität: 01.04.2008 AT 5082008
(43) Veröffentlichungstag der Anmeldung: 15.12.2010
(73) Patentinhaber: AVL List GmbH, 8020 Graz (AT)
(72) Erfinder: PRENNINGER, Peter, A-8010 Graz (AT); RAMSCHAK, Erich, A-8071 Hausmannstätten (AT); FISCHER, Robert, A-8010 Graz (AT)
(74) Vertreter: Babeluk, Michael
(86) Internationale Anmeldenummer: PCT/EP2009/053594
(87) Internationale Veröffentlichungsnummer: WO 2009/121794

(56) Entgegenhaltungen:
- WO-A-2007/066911
- US-A- 4 687 996
- US-A- 6 002 238
- US-A1- 2003 206 021

## Beschreibung

Die Erfindung betrifft ein Verfahren und eine Vorrichtung zur Überwachung des Betriebszustandes einer Batterie, vorzugsweise einer Ni-Metallhydrid- oder einer Li-Ionen-Batterie, bestehend aus einer oder mehreren zusammengeschalteten Batteriezellen. Im Folgenden wird unter dem Begriff Batterie auch ein Batteriepack bzw. Batteriestapel aus mehreren seriell oder parallel geschalteten Batterien verstanden.

Wiederaufladbare Hochleistungsbatterien bzw. Akkumulatoren werden in modernen Antriebssystemen in Kombination mit Elektromaschinen zur Speicherung von Bremsenergie sowie als Energiequelle für vollständigen oder teilweisen elektromotorischen Betrieb von Fahrzeugen verwendet. Diese Hochleistungsbatterien sind meist Ni-Metallhydrid- oder Li-Ionen-Batterien in unterschiedlichen Ausführungen. Während der Lebensdauer der Batterien verschlechtert sich deren Ladekapazität sowie deren Lade- und Entladecharakteristik auf Grund von chemischen Veränderungsprozessen an den Elektroden wie auch im Elektrolyten. Ferner sind die Lade- und Entladecharakteristiken nahe der vollständigen Ladung bzw. Entladung nicht mehr linear, da diese Vorgänge diffusionsbestimmt sind und nahe der vollständigen Ladung bzw. Entladung die Diffusionswiderstände stark zunehmen. Letztlich sind die Lade- und Entladevorgänge damit auch sehr stark vom thermischen Zustand der Batterien abhängig, da die Diffusionsvorgänge stark temperaturabhängig sind.

Ein längerer Betrieb einer Batterie in diesen extremen Ladezuständen bzw. unter betrieblichen (thermischen) Randbedingungen, die zu solch aufgeprägt nichtlinearen Betriebscharakteristika führen, verursacht in der Regel verstärkte Schädigungseffekte, weshalb diese extremen Ladezustände (Über- und Tiefentladung) vermieden werden müssen.

Beim gegenwärtigen Stand der Technik wird jede einzelne Batterie- bzw. Akkumulatorzelle kontaktiert und messtechnisch in Bezug auf Einhaltung bestimmter Spannungsschwellen überwacht. Dies erfordert bei Einheiten mit vielen einzeln in Serie geschalteten Zellen einen großen messtechnischen und Datenverarbeitungs-Aufwand, wodurch der Preis und die Zuverlässigkeit des Batteriesystems nachteilig beeinflusst werden.

Eine andere Möglichkeit besteht darin, diese extremen Zustände dadurch zu vermeiden, dass mathematische Modelle zuerst erstellt und parametriert werden, die eine Berechnung sowohl des Ladezustandes (State of Charge - SOC) als auch des Alterungszustandes (State of Health - SOH) der Batterie ermöglichen. Problematisch ist dabei ein kontinuierliches Anwachsen einer Differenz zwischen realen und berechneten Zuständen, wenn entweder die Modelle nicht exakt genug sind oder unerwartete Langzeiteffekte auftreten, die in den Modellen nicht berücksichtigt sind.

Aus der JP 2001/076752 A ist Verfahren bekannt, das eine reproduzierbare Methode zur Qualitätssicherung während der Fertigung von Batterien beschreibt. Diese Methode dient zur frühzeitigen Erkennung von beispielsweise Fremdmaterialeinflüssen in Batterieelementen und gegebenenfalls deren Ausscheidung während der Fertigung. Der Test wird vor der Befüllung mit einem Elektrolyten bei Zellen, bestehend aus einer positiven und einer negativen Elektrode und einem dazwischen angeordneten Separator, angewandt.

Physikalischer Messparameter ist der Klirrfaktor eines Wechselstromsignals. Für die Klirrfaktor-Messung über die positive und die negative Elektrode wird ein kontrolliertes Signal auf die Zwischenelektrode eingespeist und die Verzerrung des Signals gemessen. Brauchbare Zellen haben einen bestimmten Widerstandswert, der sich ändert wenn Fremdmaterial im Separator ist. Die Zelle wird als defekt eingestuft, wenn das Signal einen vorgebbaren Schwellwert überschreitet.

US 2003/0206021 A1 offenbart ein ähnliches Verfahren.

Aus der EP 1 260 824 A1 ist es bekannt, mit Hilfe der elektrischen Impedanzspektroskopie (= frequenzaufgelöstes komplexes Widerstandsdiagramm) Batterien, d.h. im speziellen automotive Bleibatterien, zu vermessen und auf Ladezustand ("SOC") und Verschleiß ("SOH") zu schließen. Im Detail werden aus den Frequenzdiagrammen einzelne Komponenten einer äquivalenten, elektrischen Ersatzschaltung extrahiert und die Änderungen ihrer Werte (Widerstand, Induktivität oder Kapazität) bewertet. Diese Methode basiert daher auf komplexer Widerstandsmessung. Ein ähnliches Bewertungsverfahren ist aus der EP 1 357 390 A1 bekannt.

Aufgabe der Erfindung ist es, ein Verfahren bzw. eine Vorrichtung zur Überwachung des Betriebszustandes einer Batterie, beispielsweise einer Ni-Metallhydrid-oder einer Li-Ionen-Batterie mit geringerem Messaufwand vorzuschlagen, wobei sowohl Defekte als auch kritische Betriebszustände der Batterie oder einzelner Batteriezellen detektiert werden sollen, um rechtzeitig erforderliche Gegenmaßnahmen zum Schutz der Batterie einleiten zu können.

Erfindungsgemäß wird diese Aufgabe durch das Verfahren gemäß Anspruch 1 gelöst.

Der Batteriezustand bzw. der Zustand der einzelnen Zellen wird somit nicht direkt sondern indirekt beobachtet. Dazu werden Nichtlinearitäten der Lade- bzw. Entladecharakteristik von Batterien genutzt. Konkret kann von einer Analyse des Klirrfaktors des Signals (definiert als das Verhältnis der Grundschwingung zu deren Oberwellenanteile), auf den Betriebszustand der Batterie während der Lade- und Entladezyklen der Batterie geschlossen werden.

In der Praxis ist die Ladung bzw. Entladung, beispielsweise bei Energiequellen für den elektromotorischen Betrieb von Fahrzeugen, die auch zur Speicherung von Bremsenergie dienen, kein zeitlich streng definierter Vorgang. Es wird einfach jene Leistung aus der Batterie entnommen, die das Fahrzeug gerade benötigt, d.h. die erfindungsgemäße Diagnose kommt in allen möglichen Betriebsmodi zur Anwendung, egal ob strom- oder spannungsgeführt be- oder entladen wird.

Eine erfindungsgemäße Vorrichtung zur Durchführung des Verfahrens ist im Anspruch 7 definiert.

### a) Batterieladevorgang

Erfindungsgemäß wird beim Ladevorgang der Batterie ein bevorzugt sinusförmiger Wechselspannungsanteil auf die Batterie (beispielsweise auf deren Ladespannung) aufgeschaltet, wobei der Oberwellenanteil des sich einstellenden Wechselstromanteils gemessen und aus dessen Zunahme auf das nahende Ende des Ladevorganges der Batterie geschlossen wird.

Durch Aufsetzen eines kleinen sinusförmigen Wechselanteils auf die Ladespannung soll die Ladeschlussspannung erkannt werden. Aufgrund von nicht linearen Batterieverhalten bzw. transienten Vorgängen in der Batterie stellt sich ein Strom ein, dessen Frequenzspektrum nicht mehr dem des aufgesetzten Signals entspricht. Neben harmonischer Verzerrung (Ausbildung von Oberwellen) kommt es zu auswertbaren Modulationseffekten um die Grundfrequenz. Auf Grund der obengenannten thermischen Effekte und Alterungseffekte verändert sich auch die Ladecharakteristik. Der Bereich mit starken Nichtlinearitäten nahe dem Ladeendzustand ist demnach variabel und kann mit der beschriebenen Diagnosetechnik kontinuierlich beobachtet und der Ladebereich jeweils optimal genutzt werden.

### b) Batterieentladevorgang

Erfindungsgemäß wird beim Entladevorgang der Batterie ein bevorzugt sinusförmiger Wechselstromanteil auf die Batterie (beispielsweise auf deren Entladestrom) aufgeschaltet, wobei der Oberwellenanteil des sich einstellenden Wechselspannungsanteils gemessen und aus dessen Zunahme auf das nahende Ende des Entladungsvorganges der Batterie geschlossen wird.

Dieser Zustand ist für jeden Batterietyp durch ein bestimmtes Spannungsniveau pro Batteriezelle bestimmt, das nicht unterschritten werden darf. Wird es dennoch unterschritten, so kann es zu einer Umpolung von Zellen mit massiven Schädigungen führen. Zwischen der vorgegebenen Minimalspannung pro Zelle und der Spannung 0 (Grenzspannung zur Umpolung) ist das Verhalten der Zelle stark Nichtlinear. Ein dem Entladestrom aufgesetztes kleines sinusförmiges Stromsignal führt zu einem verzerrten Spannungssignal. Das Frequenzspektrum des Spannungssignals unterscheidet sich wieder von dem des aufgesetzten Sinussignals. Diese Verzerrung kann auch in dem Fall beobachtet werden, dass mehrere Zellen in Serie geschaltet sind und nur eine oder wenige Zellen bereits im kritischen Bereich betrieben werden. Die gegenständliche Diagnosetechnik wird somit bei jedem Entladevorgang aufgeschaltet und beobachtet kontinuierlich allfällige nichtlineare Anteile im Spannungsantwortsignal der Batterie oder eines Batteriestapels.

Diese Kennwerte für Ladung und Entladung können in der Folge sowohl zur Anpassung der Betriebsstrategie des gesamten Antriebssystems, zur Fahrzeugdiagnose (On-Board Diagnosis - OBD) als auch zur Werkstattdiagnose verwendet werden.

Die gemessenen Strom- und Spannungssignale können während des Lade- bzw. Entladevorganges der Batterie durch eine Transformation von Spannung und Strom in den Zeit-Frequenzbereich oder durch eine Fourier-Transformation ausgewertet werden.

Erfindungsgemäß kann das eingeprägte Strom- oder Spannungssignal zumindest eine Frequenz f1, vorzugsweise mehrere, überlagerte Frequenzen f1, f2, f3 im Bereich von 0.1 Hz bis 1000 Hz, vorzugsweise im Bereich von 10 Hz, aufweisen.

Die Erfindung wird im Folgenden anhand von schematischen Darstellungen und Diagrammen näher erläutert. Es zeigen:
- Fig. 1: ein Schaltbild zur Überprüfung des Betriebszustandes einer Batterie während der Aufladung bzw. der Entladung der Batterie;
- Fig. 2: das Zeitdiagramm eines Entladevorganges einer Batterie mit eingeprägtem Signal f1;
- Fig. 3: das Zeitdiagramm eines Aufladevorganges einer Batterie mit eingeprägtem Signal f1;
- Fig. 4: das Zeitdiagramm eines Entladevorganges einer Batterie mit einem eingeprägten Summensignal aus drei verschiedenen Frequenzen f1 bis f3; sowie
- Fig. 5: das Zeitdiagramm eines Aufladevorganges einer Batterie mit einem eingeprägten Summensignal aus drei verschiedenen Frequenzen f1 bis f3.

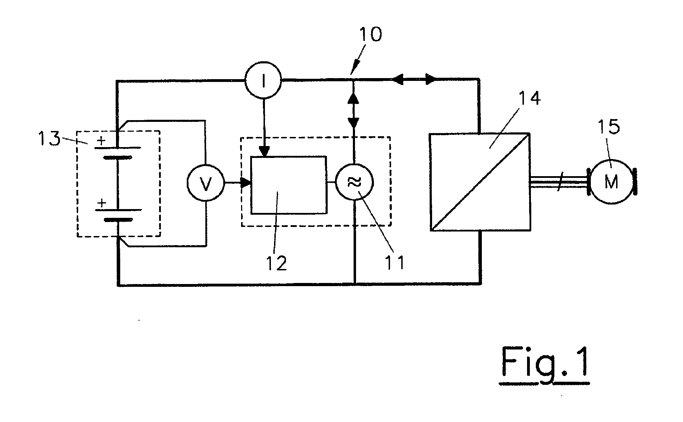

Das in Fig. 1 dargestellte Schaltbild weist einen Schaltkreis 10 mit einem Signalgenerator 11 auf, mit welchem beispielsweise ein kleiner Wechselstrom auf eine aufladbare Batterie 13 (beispielsweise eine Li-Ionen-Akku mit zwei Zellen) geschaltet wird. Es ist auch möglich der Batterie 13 eine kleine Wechselspannung zu überlagern. Als Signalantwort wird der Laststrom I und/oder die Batteriespannung U gemessen und einer Auswerteeinrichtung 12 zugeführt. In der Auswerteeinrichtung 12 wird eine Signalanalyse durchgeführt und aus zumindest einer Änderung des Oberwellenanteils des gemessenen Spannungs- oder Stromsignals (beispielsweise einer Zunahme des Klirrfaktors) auf den Betriebszustand der Batterie 13 geschlossen. Mit 15 ist eine elektrische Last, beispielsweise ein Elektromotor, bezeichnet, welcher über einen Umrichter (DC/DC) oder einen Konverter (DC/AC) 14 mit der Batterie 13 verbunden ist.

Die folgenden Testergebnisse wurden von einer Li-Ionen-Batterie gewonnen, welche folgende Parameter aufweist: Kapazität 800mAh, Aufladeschlussspannung 4,2V (+/- 50mV), typische Spannung 3,6V, Entlade-Schlussspannung 2,4V (+/- 50mV), maximale Temperatur beim Aufladen 40°C, maximale Temperatur beim Entladen 60°C.

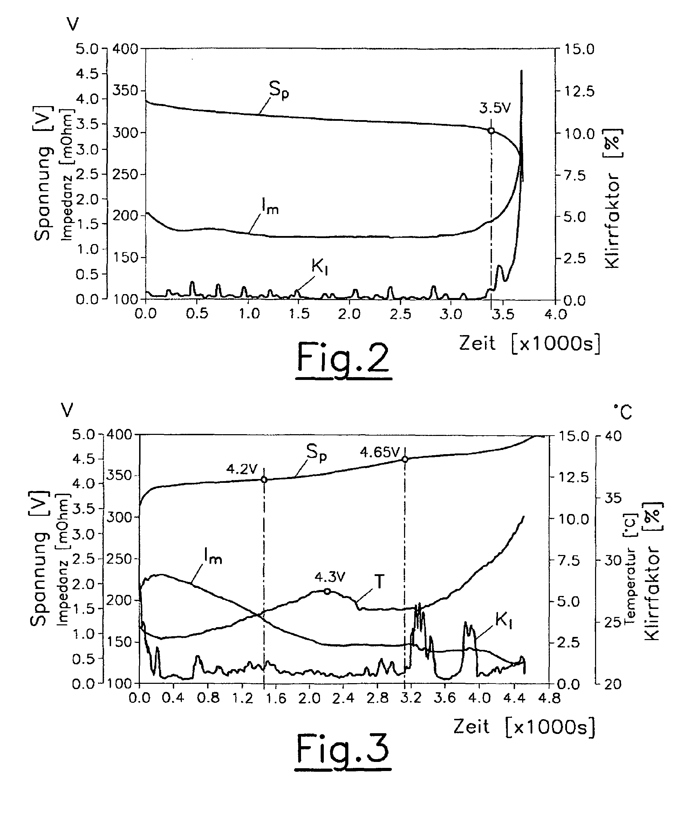

Fig. 2 zeigt einen Entladevorgang mit einem auf den Entladestrom aufgeprägten Sinussignal. Aus dem Diagramm ist ein Klirrfaktoranstieg um ca. 10% ab einer Spannung Sₚ von 3,5V erkennbar. Im Versuchsaufbau wurde aus Vergleichsgründen gleichzeitig die Impedanz Im gemessen, wobei jedoch eine Impedanzmessung für das erfindungsgemäße Verfahren nicht notwendig ist. Erkennbar ist, dass der Verlauf des Klirrfaktors Kₗ mit dem Verlauf der Impedanz Im korreliert.

In Fig. 3 ist das Zeitdiagramm eines Aufladeversuchs dargestellt, welcher bis zur Zerstörung der Batterie durchgeführt wurde. Ab 4,65V Batteriespannung Sₚ ist ein Anstieg des Klirrfaktors Kₗ um 5% erkennbar. Der Anstieg des Klirrfaktors korreliert mit dem Anstieg der Temperatur T, was auf eine Schädigung der Batterie hinweist.

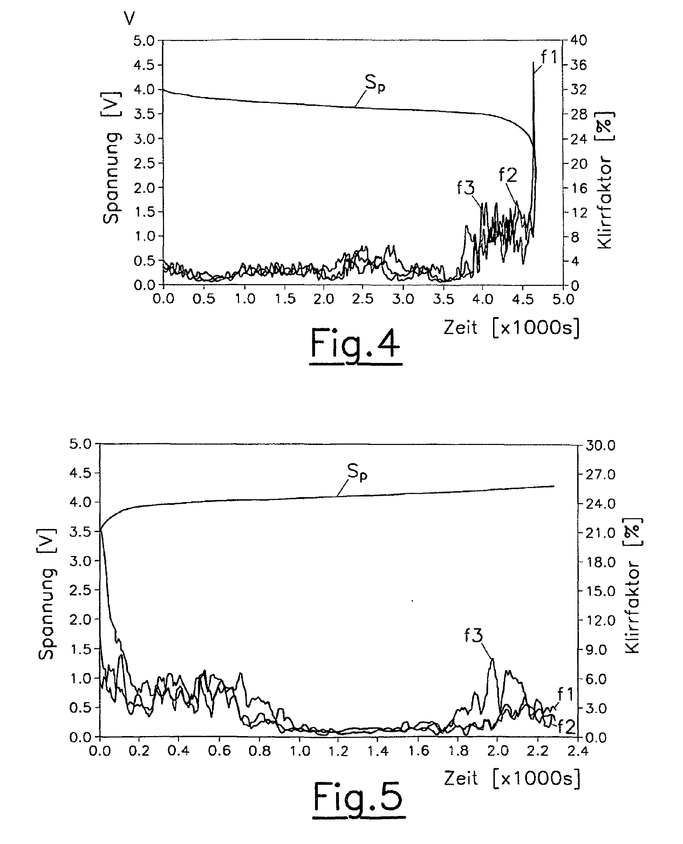

In den Fig. 4 und Fig. 5 sind die zeitlichen Diagramme einer Entladung (Fig. 4) und einer Aufladung (Fig. 5) der Batterie dargestellt, wobei jeweils drei verschiedene Frequenzen f1 (0.7Hz), f2 (5.6Hz) und f3 (12.9Hz) eingeprägt wurden. Aus Fig. 4 ergibt sich ein Indiz für eine frequenzabhängige Selektivität derart, dass höhere Frequenzen als früher auf kritische Veränderungen in der Batterie reagieren. Auch aus Fig. 5 ist erkennbar, dass der Anstieg des Klirrfaktors bei unterschiedlichen Frequenzen f1 bis f3 variiert. Je nach Art der überwachten Batterie ist somit die Festlegung einer optimalen Frequenz bzw. eines optimalen Frequenzbandes möglich.

## Patentansprüche

1. Verfahren zur Überwachung des Betriebszustandes einer Ni-Metallhydrid-oder einer Li-Ionen-Batterie, bestehend aus mehreren zusammengeschalteten Batteriezellen, **dadurch gekennzeichnet, dass** während der Aufladung oder der Entladung der Batterie ein niederfrequentes Wechselstrom-oder Wechselspannungssignal auf die Batterie aufgeschaltet wird, dass das sich ergebende Spannungs- oder Stromsignal gemessen wird und dass aus zumindest einer Änderung des Oberwellenanteils des gemessenen Spannungs- oder Stromsignals auf den Betriebszustand der Batterie oder deren Batteriezellen geschlossen wird, wobei von einem sich vergrößernden Oberwellenanteil des gemessenen Spannungs- oder Stromsignals auf einen nichtlinearen Betriebszustand am Ende des Lade- oder Entladevorganges der Batterie geschlossen wird.

2. Verfahren nach Anspruch 1, **dadurch gekennzeichnet, dass** beim Ladevorgang der Batterie ein sinusförmiger Wechselspannungsanteil auf die Ladespannung der Batterie aufgeschaltet wird, wobei der Oberwellenanteil des sich einstellenden Wechselstromanteils gemessen und aus dessen Zunahme auf das nahende Ende des Ladevorganges der Batterie geschlossen wird.

3. Verfahren nach Anspruch 1, **dadurch gekennzeichnet, dass** beim Entladevorgang der Batterie ein sinusförmiger Wechselstromanteil auf den Entladestrom der Batterie aufgeschaltet wird, wobei der Oberwellenanteil des sich einstellenden Wechselspannungsanteils gemessen und aus dessen Zunahme auf das nahende Ende des Entladungsvorganges der Batterie geschlossen wird.

4. Verfahren nach einem der Ansprüche 1 bis 3, **dadurch gekennzeichnet, dass** die gemessenen Strom- und Spannungssignale während des Lade-oder Entladevorganges der Batterie durch eine Transformation von Spannung und Strom in den Zeit-Frequenzbereich oder durch eine reine Frequenz-Transformation ausgewertet werden.

5. Verfahren nach einem der Ansprüche 1 bis 4, **dadurch gekennzeichnet, dass** der Ladespannung oder dem Ladestrom der Batterie zumindest ein niederfrequentes, sinusförmiges Strom- oder Spannungssignal eingeprägt wird.

6. Verfahren nach einem der Ansprüche 1 bis 5, **dadurch gekennzeichnet, dass** das eingeprägte Strom- oder Spannungssignal zumindest eine Frequenz f1, vorzugsweise mehrere, überlagerte Frequenzen f1, f2, f3 im Bereich von 0.1 Hz bis 1000 Hz, vorzugsweise im Bereich von 10 Hz, aufweist.

7. Vorrichtung zur Überwachung des Betriebszustandes einer Ni-Metallhydrid-oder einer Li-Ionen-Batterie (13), bestehend aus mehreren zusammengeschalteten Batteriezellen, **dadurch gekennzeichnet, dass** die Batterie (13) in einem Schaltkreis (10) angeordnet ist, welcher einen Signalgenerator (11) zur Aufschaltung eines niederfrequenten Wechselstrom- oder Wechselspannungssignals auf die Batterie (13) aufweist, sowie dass eine Auswerteeinrichtung (15) vorgesehen ist, mit welcher aus einem sich vergrößernden Oberwellenanteil des gemessenen Spannungs- (U) oder Stromsignals (I) auf einen nichtlinearen Betriebszustand am Ende des Lade- oder Entladevorganges der Batterie (13) geschlossen wird.

## Claims

1. A method for monitoring the operating state of an Ni metal hydride or Li-ion battery, consisting of several interconnected battery cells, **characterised in that** during the charging or discharging of the battery a low-frequency alternating current or alternating voltage signal is applied to the battery, the resulting voltage or current signal is measured and the operating state of the battery or its battery cells is determined from at least one change in the harmonic fraction of the measured voltage or current signal, with conclusions being drawn on a non-linear operating state at the end of the charging or discharging process of the battery from an increasing harmonic fraction of the measured voltage or current signal.

2. A method according to claim 1, **characterised in that** during the charging process of the battery a sinusoidal alternating voltage fraction is applied to the charging voltage of the battery, with the harmonic fraction of the obtained alternating current fraction being measured and conclusions being drawn from its increase on the approaching end of the charging process of the battery.

3. A method according to claim 1, **characterised in that** during the discharging process of the battery a sinusoidal alternating current fraction is applied to the discharging current of the battery, with the harmonic fraction of the occurring alternating voltage fraction being measured and conclusions being drawn from its increase on the approaching end of the discharging process of the battery.

4. A method according to one of the claims 1 to 3, **characterised in that** the measured current and voltage signals are evaluated during the charging and discharging process of the battery by a transformation of voltage and current into the time-frequency range or by a pure frequency transformation.

5. A method according to one of the claims 1 to 4, **characterised in that** the charging voltage or charging current of the battery is impressed with at least one low-frequency sinusoidal current or voltage signal.

6. A method according to one of the claims 1 to 5, **characterised in that** the impressed current or voltage signal comprises at least one frequency f1, preferably several superimposed frequencies f1, f2, f3 in the range of 0.1 Hz to 1000 Hz, preferably in the range of 10 Hz.

7. An apparatus for monitoring the operating state of an Ni metal hydride or Li-ion battery (13), consisting of several interconnected battery cells, **characterised in that** the battery (13) is arranged in a circuit (10) which comprises a signal generator (11) for applying a low-frequency alternating current or alternating voltage signal to the battery (13), and an evaluation device (15) is provided with which it is possible to draw conclusions on a non-linear operating state at the end of the charging or discharging process of the battery (13) from an increasing harmonic fraction of the measured voltage (U) or current signal (I).

## Revendications

1. Procédé pour contrôler l'état de fonctionnement d'une batterie nickel-hydrure métallique ou d'une batterie lithium-ion constituée de plusieurs cellules de batterie reliées entre elles,
**caractérisé en ce que**
pendant la charge ou la décharge de la batterie, on transmet à celle-ci un signal de tension alternative ou un signal de courant alternatif basse fréquence on mesure le signal de tension ou le signal de courant ou résultant, à partir d'au moins une variation de la proportion d'harmoniques dans le signal de courant ou le signal de tension mesuré on déduit l'état de fonctionnement de la batterie ou de ses cellules de batterie, et en présence d'une augmentation de la proportion d'harmoniques dans le signal de courant ou le signal de tension on déduit un état de fonctionnement non linéaire indicatif de la fin du processus de charge ou de décharge de la batterie.

2. Procédé conforme à la revendication 1,
**caractérisé en ce que**
lors du processus de charge de la batterie on transmet une fraction de tension alternative sinusoïdale à la tension de charge, de la batterie, on mesure la proportion d'harmoniques dans la fraction de courant alternatif qui s'établit et on déduit d'une augmentation de cette proportion la proximité de la fin du processus de charge de la batterie.

3. Procédé conforme à la revendication 1,
**caractérisé en ce que**
lors du processus de décharge de la batterie on transmet une fraction de courant alternatif sinusoïdal au courant de décharge de la batterie, on mesure la proportion d'harmoniques dans la fraction de tension alternative qui s'établit et on déduit d'une augmentation de cette proportion la proximité de la fin du processus de décharge de la batterie.

4. Procédé conforme à l'une des revendications 1 à 3,
**caractérisé en ce que**
l'on exploite les signaux de courant et les signaux de tension mesurés, pendant le processus de charge ou pendant le processus de décharge de la batterie par une transformation de la tension et du courant dans la plage de fréquence chronologique ou par une transformation de fréquence pure.

5. Procédé conforme à l'une des revendications 1 à 4,
**caractérisé en ce que**
l'on applique à la tension de charge ou au courant de charge de la batterie au moins un signal de courant ou de fréquence sinusoïdal basse fréquence.

6. Procédé conforme à l'une des revendications 1 à 5,
**caractérisé en ce que**
le signal de courant ou de fréquence appliqué comporte au moins une fréquence (f1), de préférence plusieurs fréquences superposées (f1, f2, f3) situées dans la plage de 0,1 Hz à 1000 Hz, de préférence dans la plage de 10 Hz.

7. Dispositif pour contrôler l'état de fonctionnement d'une batterie nickel-hydrure métallique ou d'une batterie lithium-ion (13) constituée de plusieurs cellules de batterie reliées entre elles,
**caractérisé en ce que**
la batterie (13) est montée dans un circuit (10) qui comporte un générateur de signal (11) pour transmettre un signal de tension alternative ou un signal de courant alternatif basse fréquence à la batterie (13), et
**en ce qu'**
il est prévu un dispositif d'exploitation (15) permettant de déduire d'une augmentation de la proportion d'harmoniques dans le signal de tension (U) ou le signal de courant (I) mesuré, un état de fonctionnement non linéaire indicatif de la fin du processus de charge ou du processus de décharge de la batterie (13).
